# EUROPEAN PATENT SPECIFICATION

(11) **EP 1 132 952 B1**
(45) Date of publication and mention of the grant of the patent: **23.11.2016**
(21) Application number: 00870040.3
(22) Date of filing: 10.03.2000
(51) Int. Cl.: H01L 21/306, H01L 21/3063, H01L 31/18

(54) **Method for the formation and lift-off of porous silicon layers**
Verfahren zur Herstellung und Abhebung von einer porösen Siliziumschicht
Procédé de formation et décollement d'une couche de silicium poreux

(43) Date of publication of application: 12.09.2001
(73) Proprietor: IMEC, 3001 Leuven (BE)
(72) Inventor: Solanki, Chetan Singh, 3000 Leuven (BE); Bilyalov, Renat, 3010 Leuven (BE); Poortmans, Jef, 3010 Leuven (BE); Beaucarne, Guy, 3010 Leuven (BE)
(74) Representative: Van Malderen, Joëlle

(56) References cited:
- EP-A- 0 226 091
- EP-A- 0 797 258
- EP-A- 0 975 012
- US-A- 5 206 523
- BILLAT S ET AL: "Influence of etch stops on the microstructure of porous Si layers" THIN SOLID FILMS, 1 APRIL 1997, vol. 297, no. 1-2, pages 22-25, XP004125956 ISSN: 0040-6090
- OOKUBO N ET AL: "Microscope observation of a self-standing film of porous silicon" MAT. SCIENCE & ENGINEERING, 30 JULY 1993, vol. B20, no. 3, pages 324-327, XP000915367 ISSN: 0921-5107
- BENDER H ET AL: "Morphological properties of porous-Si for n+ emitter applications" APPLIED SURFACE SCIENCE, 1 MAY 1999, vol. 147, no. 1-4, pages 187-200, XP000900480 ISSN: 0169-4332

## Description

### Field of the invention

The present invention is situated in the field of micro-electronics, more precisely in the field of the formation of porous silicon layers (PSL) and its lift-off to manufacture Silicon On Insulator (SOI) structures or to bond it to other low-cost substrates for the fabrication of photovoltaic cells.

### State of the art

When manufacturing a solar cell, only the top few microns of a silicon wafer will participate actively in the conversion of solar energy. Most of the expensive silicon wafer will only provide mechanical strength to the cell. This function can be achieved by any other low-cost substrate compatible to the solar cell fabrication process. Thus cost reduction is possible by providing a reduction in the use of silicon.

Silicon on insulator (SOI) structures are well known in the art, for example in the manufacture of low-cost solar cells with high efficiency. Some of the advantages are prevention of latch-up, low parasitic capacitance, high-speed operation and the absence of a need for a welling process.

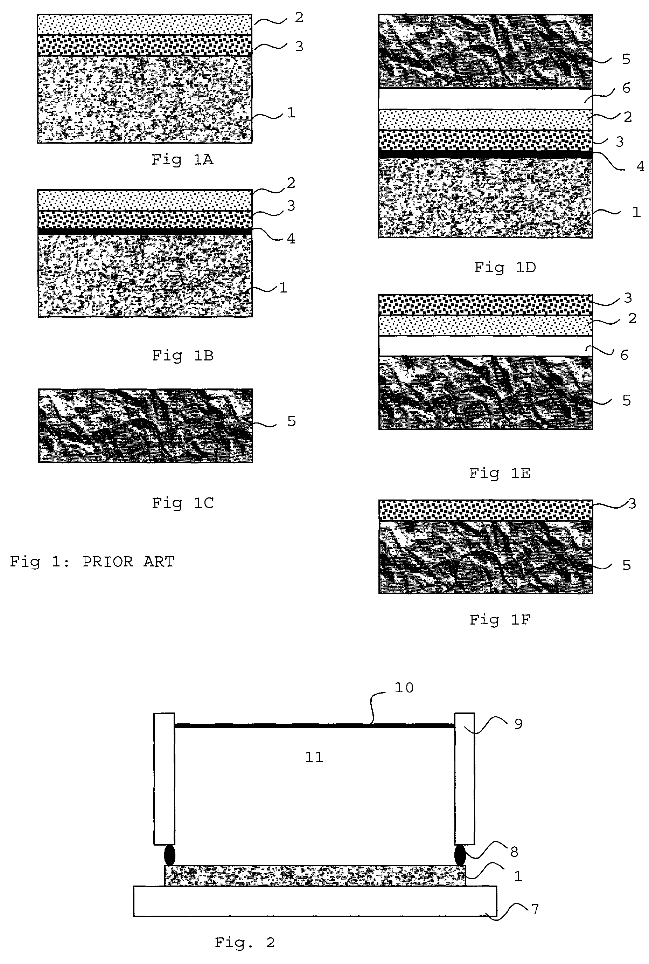

In general, the existing techniques for the formation of PSLs and to transfer them to other substrates can be seen in figure 1 and involve the following three steps:
- Formation in a silicon substrate 1 of a low porosity layer 2 on the surface and a high porosity layer 3 thereunder by anodisation of silicon in hydrofluoric acid by changing the current density during the PSL formation.
- Formation of a separation layer 4 under the high porosity layer 3 by high temperature annealing in hydrogen. This separation layer is a highly porous layer and is mechanically very weak. It can easily be broken by little mechanical force, e.g. by ultrasonic treatment or pulling.
- Bonding of the obtained structure to another substrate 5 using an adhesive 6.

This process is disclosed in figures 1A through 1F.

These techniques have been discussed by H.Tayanaka et al., 2nd world conference and exhibition on photovoltic solar energy conversion, Vienna, Austria, 1272 (1998), and by T.J.Rinker et al., Applied Physics A, 68, 705-707 (1999).

Another approach, disclosed by T.Yonehara et al. in Electrical Society Proceedings, Volume 99-3, 111, uses mechanical grinding, selective etching and hydrogen annealing for transferring thin silicon epi layers on the other substrate. The European patent application EP 0867920 discussed the use of a laser beam for the separation of the thin layer from the silicon substrate.

Billat S. et al, in Thin Solid Films vol. 297 no. 1-2 (1997) page 22-25, discloses a method for the formation of porous silicon (PS) layers, performed by interrupting the etch process several times during the formation. The introduction of these etch stops during the formation process has a significant influence on the microstructure of PS. By this method, the hydrofluoric acid (HF) concentration in the electrolyte can return to its original level, which allows the fabrication of stable interference filters.

Ookubo N. et al, in Materials Science and Engineering vol. B20 no. 3 (1993) page 324-327, discloses a self-standing film (SSF) of porous silicon (Si) electrochemically isolated from the Si substrate by increasing the current density to 0.4 A/cm². The porous Si SSF undergoes expansion and shrinkage upon wetting with methanol and upon drying, respectively, demonstrating that the porous Si SSF behaves like a sponge. The expansion-shrinkage process can be repeated.

Bender H. et al, in Applied Surface Science vol. 147 no. 1-4 (1999) page 187-200, investigates the morphological properties of porous silicon formed by anodic treatment of n⁺ silicon layers. The layers show a mesoporous structure with a porosity that increases with doping level. The porosity of the layers increases for increasing doping level and saturates at a doping above about 5×10¹⁹/cm³. The formation rate shows an inverse doping dependence. The top surface layer of the porous silicon is more dense than the bulk, which is related to an initially faster formation rate.

All of the above-mentioned procedures for forming a thin porous layer and separating it from the substrate involve multiple steps, some of which are complex. Each step adds to the cost of the SOI structure or solar cell.

### Aims of the invention

The primary aim of the present invention is to provide a novel, one step method for the production of porous layer films. A further aim of the invention is to provide a novel method for the production of porous layer films that allows good control over the pore depth. Another aim of the present invention is to provide a novel method for the production of porous layer films in which the substrate is available without aftertreatment after lift-off of the porous layer film for the production of a further porous layer film.

### Summary of the invention

The present invention concerns a method for the manufacture of porous layers in a silicon (semiconductor) substrate, comprising the following steps:
- Providing a silicon (semiconductor) substrate comprising at least one surface, said substrate serving as an cathode,
- Providing a anode,
- Applying a first solution comprising F⁻ ions, wherein the concentration of the F⁻ is comprised between 10% and 40%, suitable for removing material from said substrate, between said surface and said anode,
- Applying a predetermined current between said anode and said cathode, this current being higher than 50 mA/cm², and
- Maintaining said solution and said current for a sufficient amount of time depending on the concentration of F- and the value of the current in order to obtain a porosity gradient wherein a low porosity layer is positioned at said surface and a high porosity layer is positioned under said low porosity layer further comprising maintaining said solution and said current a further amount of time in order to obtain lift-off of said low porosity layer and a part of said high-porosity layer from said substrate.

With this novel method, a porous semiconductor film comprising a low porosity and a high porosity layer can be obtained with a one-step method, i.e. without changing any parameter. More specifically, the solution will not be replaced and the current will not be changed. For the purpose of the invention, layer shall be understood as a part of the substrate that can be distinguished from another part of the substrate.

The amount of time the current and the composition of the solution have to be maintained thus depends on the value of the current and of the concentration of the F- ions in the solution and can be determined by the person skilled in the art based on the examples as disclosed in the detailed description. A F- ion containing solution can be obtained by dissolving HF, a buffer solution containing F⁻ ions, NH₄F, NaF or any other F- containing compound into an aqueous solution. Further, said solution preferably further comprises a wetting agent such as an organic solvent, preferably, but not limited to ethanol or acetic acid.

With the method of the invention, a porous layer comprising a low porosity layer and a high porosity layer positioned thereunder can thus be obtained.

The concentration of F- ions depends on the ionisation constant of the fluorine containing compound. The concentration of F⁻ in said solution is comprised between 10 and 40%.

The value of said current is higher than 50 mA/cm². The upper limit of the current is usually determined by the equipment and/or material constraints.

The method of the present invention can further comprise the step of halting the application of current for a short time, and reapplying the current to obtain a higher thickness of the porous layers. Halting the application of the current will allow the hydrogen to escape before its pressure allows horizontal cracks to occur. By repeating this several time, a porous layer with a desired thickness can easily be obtained.

In an alternative example not according to the present invention, the method can further comprise a mechanical treatment to obtain lift-off of said low porosity layer and part of said high-porosity layer from said substrate. Said mechanical treatment can be any of the known treatments such as ultrasonic treatment, pulling, etc... .

The method of the present invention thus comprises the step of maintaining said solution and said current a further amount of time in order to obtain lift-off of said low porosity layer and a part of said high-porosity layer from said substrate. This allows obtaining a separated porous layer film which can be attached to a suitable low-cost substrate.
Said separated porous layer film can comprise said low porosity layer and a part of said high porosity layer. Said part of said high porosity layer can be understood as no high porosity layer or a certain thickness lower than the high porosity layer before separation.

In another alternative example not according to the present invention, the method further comprises applying a second aqueous solution, suitable for electro-polishing the substrate and for providing separation and lift-off of the low porosity layer and a part of the high-porosity layer from the substrate and for providing a new polished surface on the substrate, while maintaining the current. Yet another alternative way not according to the present invention to obtain the same effects is to apply in a further step a higher current, suitable for electro-polishing the substrate and for providing separation and lift-off of the low porosity layer and a part of the high-porosity layer from the substrate and for providing a new polished surface on the substrate, while maintaining the solution. By using this process, the semiconductor substrate surface is polished after removal of the porous layers and thus no aftertreatment of the semiconductor substrate is necessary to proceed to the manufacture of a further porous layer film.

### Short description of the drawings

Figures 1A, 1B, 1C, 1D, 1E and 1F illustrate the prior art technique and shows the steps used for the formation of porous layer and its separation from the substrate.
Figure 2 illustrates the experimental set-up.
Figure 3A and 3B respectively are pictures of the interface between bulk silicon and porous layer just before separation and of the pore structure.
Figure 4 illustrates the electrochemical etching reaction at the interface of the HF solution and silicon.
Figures 5A to 5H illustrate the porous silicon layer formation and its separation mechanism from the reusable substrate.

### Detailed description of the invention

In relation to the appended drawings the present invention is described in detail in the sequel. Several embodiments are disclosed. It is apparent however that a person skilled in the art can imagine several equivalent embodiments or other ways of practicing the present invention, the scope thereof being limited only by the claims.

The present invention provides a simple technique of formation and lift-off (separation) of thin film from the substrate. With this approach the remaining wafer (after removing the thin layer) can be used again as starting product for manufacturing more thin films.

The approach of the present invention of formation and separation of PSL requires only a single step as compared to the multiple, complex steps required in all other existing approaches. Porous silicon layers are formed by anodization, which is the electrochemical etching of silicon in the solution based on hydrofluoric acid. If one carries out the anodization for a sufficient time and for a given current density, pores travel straight down in the silicon. When a certain pore depth is reached, the concentration of fluoride at the point of the reaction decreases. Branching of pores gives rise to the separation layer. The separated layer can be used for any desired use. Thus, in this way, one can avoid the following steps of the formation and separation of thin film from the substrate:
(a) No replacement of the solution comprising F ions is required.
(b) No change in the current density is required for forming double porosity structure.
(c) No high temperature annealing in hydrogen is required for making the separation layer.
(d) No mechanical force is required to separate the layer from the substrate.

Another approach not according to the present invention, which provides better control over separation of the layer from the substrate, involves two steps. In the first step one carries out the electrochemical etching as stated above and in the second step one exploits an electro-polishing regime for the formation of the separation layer.

The present invention is described by reference to examples 1 to 4. The example 1 describes the set-up used for the porous silicon formation. Porous silicon formation and its separation from the reusable substrate by electrochemical etching are described in the example 2. Formation mechanism of a separation layer or a detached layer is described in the example 3. In a part of example 4, the electrochemical reaction is limited by the fluoride ion in the solution, known as electro-polishing, which is an example not according to the present invention. The combination of electrochemical etching and electro-polishing with certain conditions can be used for the PSL and its separation from the reusable substrate.

### Example 1: Experimental setup.

Figure 2 illustrates the experimental set-up used for the porous silicon layer formation. Reference numeral 11 is the hydrofluoric acid solution. In the porous silicon formation the platinum electrode 10, which is resistant against hydrofluoric acid, acts as a negative electrode. The bottom plate 7 (e.g. stainless steel plate), which is in contact with the silicon wafer 1 (polished side up), acts as cathode. The rubber ring 8 prevents the outflow of the solution from the contact area of the Teflon® beaker 9 and wafer substrate 1. The rubber ring 8 is kept under pressure by the beaker 9, which in turn is pressurised by a stainless steel threaded ring (not shown).

### Example 2:

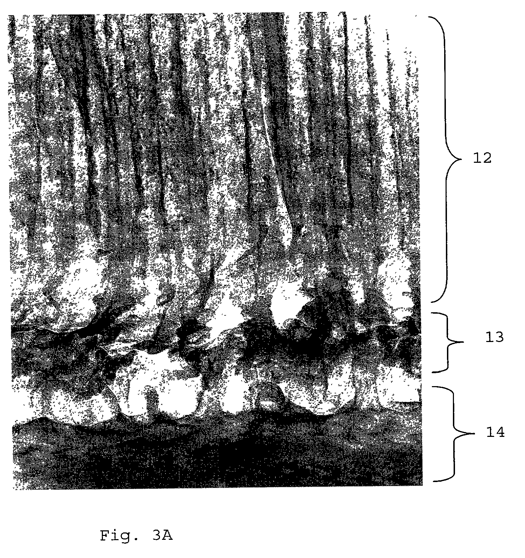

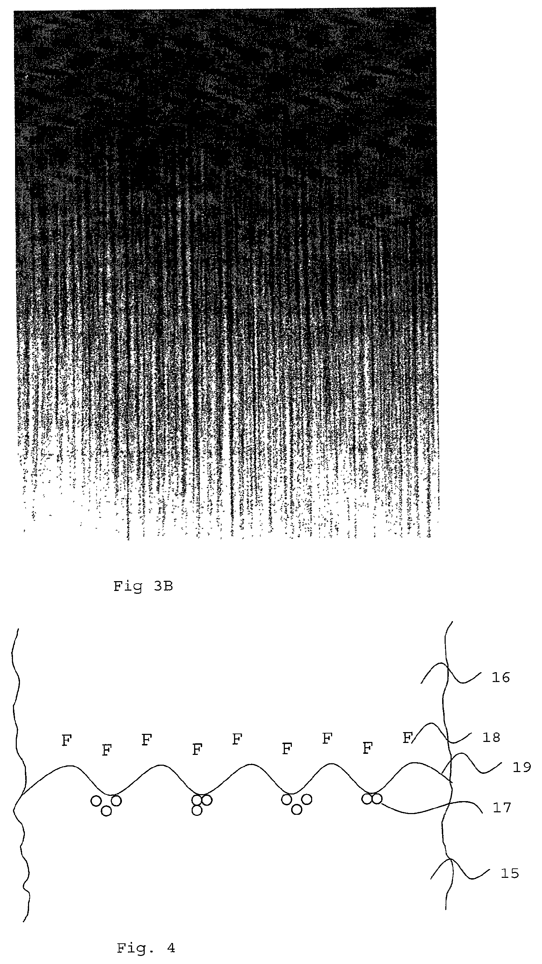

Experiments were carried out with a mixture of HF, acetic acid and deionised water in which the concentration of HF varies between the different experiments from 10% to 40% and current density varies from 25 mA/cm² to 200 mA/cm². The acetic acid is used as a wetting agent, and provides enough functionality to obtain a good pore distribution. Ethanol could also be used, but for environmental reasons acetic acid is preferred. For a given current density and for a given HF concentration, formation of the separation layer or a very high porosity layer or a detached layer as shown in Figure 3A is obtained when the reaction is continued after a certain time. The low porosity layer 12, high porosity (separation) layer 13 just before lift-off and silicon wafer substrate 14 are visible on figure 3A. For a 25% HF solution and for 150 mA/cm² current density this time is around 45-55 second and the thickness of the thin layer obtained is around 7 to 10 microns. Different layer thickness can be achieved by changing the current density and HF concentration in the solution. During the etching the pore extends downward in the silicon wafer as shown in Figure 3B. Pores are not perfectly cylindrical in shape. For all experiments highly doped silicon wafers of orientation <100> were used.

### Example 3:

Electrochemical etching of silicon occurs at the HF solution/silicon interface when subjected to the flow of current. When a hole coming from the bulk silicon reaches to the interface, the Si-H bond is replaced by Si-F bond due to an attack by a fluoride ion from the HF solution. The polarization induced by these Si-F bond lowers the electron density of the Si-Si bond and these are broken too. Silicon dissolves as tetravalent silicon fluoride (SiF₄), which reacts with HF and produces fluorosilicic acid (H₂SiF₆). This electrochemical reaction is limited to the holes and results in pore formation. Figure 4 illustrates the interface between bulk silicon and the HF solution where pore formation occurs. The numeral 15 indicates bulk silicon, 16 is the HF solution, 17 designates the holes, 18 are the fluoride ions and 19 is the interface.

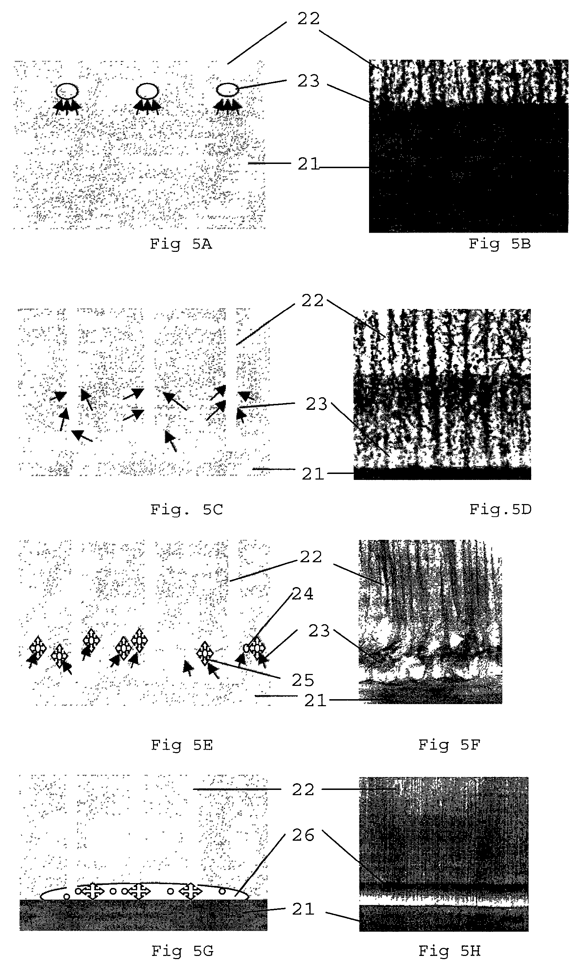

Once the pore formation starts at a certain position, it goes straight down in silicon as shown in Figure 5. The numeral 21 indicates bulk silicon, 22 indicates pores and 23 indicates the point of reaction. When the pores are not deep enough the reaction occurs at the bottom of the pore as shown in Figure 5A and 5B. At this time, there are sufficient fluoride ions available at the bottom but certainly less than the number of fluoride ions available at the surface since they have to diffuse through the pore to the point of reaction. Porosity of the layer increases with decrease in the concentration of HF in solution. Although the initial F- containing solution is not replaced, an in-situ change of concentration is obtained. Therefore as we go deeper, porosity of the layer increases. The porosity gradient occurs from the point where the availability of the fluoride ion is affected by the diffusion through pores.

As pores go sufficiently deep in silicon, the fluoride ion concentration at the point of reaction reduces to a very low level as compared to the surface concentration. This results in the shift of the point of reaction to a slightly higher level because of very high resistance of the lowest part of the pore as shown in Figure 5C and 5D. This shift in the reaction gives rise to the formation of the branches of the pores as shown in Figure 5E and 5F. In Figure 5E the numeral 24 indicates a hydrogen molecule and 25 is the direction of the hydrodynamic force exerted by the molecule. For every dissolution of a silicon atom, one hydrogen molecule results as a product of the electrochemical etching. The hydrogen molecules exert force on the walls of the pores. At some points, because of the branching of pores the walls becomes very thin and not able to withstand the hydrodynamic pressure exerted by the hydrogen molecules. This results in horizontal cracks 26 in the layer. The presence of sufficient horizontal cracks results in the separation of the layer from the substrate. The layer can then detach from the substrate as shown in Figure 5G and H.

### Example 4:

For the case of 25 % HF solution and 150 mA/cm² current density the separation of the PSL occurs at around 45-55 seconds. Because of the high current density, reaction occurs very fast. The centre portion of the layer gets detached with the wafer but the periphery remains attached with the silicon because of the construction of the experimental set-up. Therefore after the formation of separation layer if the reaction is allowed to continue, the by-product, hydrogen, gathers underneath the layer and exerts pressure on the film. The film breaks because of this pressure. Therefore, exact control of the reaction is required.

In another approach not according to the present invention, which comprises two steps, one can exploit the use of electro-polishing together with the electrochemical etching for the formation of separation layer. For this purpose, polishing shall be understood as etching a rough surface such that the uneven topography of the surface decreases. Electrochemical etching is carried out with the set-up described in example 1. In the first step one forms porous silicon layer and in the second step changing the solution from high concentration to low concentration of F⁻ results in electro-polishing. For example in the first step one uses 25% HF and 150 mA/cm² current density during 45 seconds. For the second step one uses a solution of low HF concentration, for example 17%. The reaction at the interface is limited by the fluoride ion concentration and electro-polishing at the interface of bulk silicon and porous layer occurs. The time required to form a separation layer in the second step varies from 60 seconds to 80 seconds. This electro-polishing effect can also be obtained by keeping the same solution, but changing (augmenting) the current.

In another approach according to the present invention, one can control the reaction that occurs at the deepest porous layer in such a way that no horizontal cracks occur. This can e.g. be done by halting the current for a short period just before the time that separation would normally occur, and then applying the current again for a short period. By doing this repeatedly, one can obtain high-thickness porous layers easily. A thickness of 70 µm is readily obtainable. Applying the current for a sufficient amount of time for horizontal cracks to occur can easily separate such thick porous layers from the substrate. Pausing the application of current allows the hydrogen to escape from the pores and can thus postpone the formation of horizontal crack due to hydrogen pressure.

## Claims

1. Method for the manufacture of porous layers in a silicon substrate (1), comprising the following steps:
• Providing a silicon substrate (1) comprising at least one surface (1'), said substrate (1) serving as a cathode (1),
• Providing an anode (10),
• Applying a first solution (11) comprising F⁻ ions, wherein the concentration of the F⁻ is comprised between 10% and 40%, suitable for removing material from said substrate (1), between said surface (1') and said anode (10),
• Applying a predetermined current between said anode (10) and said cathode (1), this current being higher than 50 mA/cm², and
• Maintaining said solution (11) and said current for a sufficient amount of time depending on the concentration of F⁻ and the value of the current in order to obtain a porosity gradient wherein a low porosity layer (2) is positioned at said surface (1') and a high porosity layer (3) is positioned under said low porosity layer (2),
further comprising maintaining said solution (11) and said current a further amount of time in order to obtain lift-off of said low porosity layer (2) and a part of said high-porosity layer (3) from said substrate (1).

2. Method as in claim 1, **characterised in that** it further comprises the step of halting the application of current for a period of time, and reapplying the current to obtain a higher thickness of the porous layers.

## Patentansprüche

1. Verfahren zur Herstellung von porösen Schichten in einem Siliciumsubstrat (1), die folgenden Schritte umfassend :
• Bereitstellen eines Siliciumsubstrats (1), das eine erste Oberfläche (1') umfasst, wobei das Substrat (1) als eine Kathode (1) dient,
• Bereitstellen einer Anode (10),
• Anwenden einer ersten Lösung (11), die F⁻-Ionen umfasst, wobei die Konzentration der F⁻ zwischen 10 % bis 40 % beträgt, was zum Entfernen von Material aus dem Substrat (1) zwischen der Oberfläche (1') und der Anode (10) geeignet ist,
• Anlegen eines vorbestimmten Stroms zwischen die Anode (10) und die Kathode (1), wobei dieser Strom höher als 50 mA/cm² ist, und
• Halten der Lösung (11) und des Stroms für eine ausreichende Zeitdauer in Abhängigkeit von der Konzentration von F⁻ und dem Wert des Stroms, um einen Porositätsgradienten zu erreichen, wobei eine Schicht (2) mit geringer Porosität an der Oberfläche (1') positioniert wird, und eine Schicht (3) mit hoher Porosität unter der Schicht (2) mit geringer Porosität positioniert wird,
ferner umfassend ein Halten der Lösung (11) und des Stroms über eine weitere Zeitdauer, um ein Abheben der Schicht (2) mit geringer Porosität (2) und eines Teils der Schicht (3) mit hoher Porosität vom Substrat (1) zu erreichen.

2. Verfahren nach Anspruch 1, **dadurch gekennzeichnet, dass** es ferner den Schritt des Stoppens des Anlegens von Strom für eine Zeitspanne und erneuten Anlegens des Stroms umfasst, um eine größere Dicke der porösen Schichten zu erreichen.

## Revendications

1. Procédé pour la fabrication de couches poreuses dans un substrat de silicium (1), comprenant les étapes suivantes :
- fourniture d'un substrat de silicium (1) comprenant au moins une surface (1'), ledit substrat (1) faisant office de cathode (1),
- fourniture d'une anode (10),
- application d'une première solution (11) comprenant des ions de F⁻, dans lequel la concentration du F⁻ est comprise entre 10 % et 40 %, appropriée pour éliminer le matériau dudit substrat (1), entre ladite surface (1') et ladite anode (10),
- application d'un courant prédéterminé entre ladite anode (10) et ladite cathode (1), ce courant étant supérieur à 50 mA/cm², et
- maintien de ladite solution (11) et dudit courant pendant une quantité de temps suffisante en fonction de la concentration de F⁻ et de la valeur du courant afin d'obtenir un gradient de porosité dans lequel une couche de faible porosité (2) est positionnée au niveau de ladite surface (1') et une couche de porosité élevée (3) est positionnée sous ladite couche de faible porosité (2),
comprenant en outre le maintien de ladite solution (11) et dudit courant pendant un temps supplémentaire afin d'obtenir un décollement de ladite couche de faible porosité (2) et d'une partie de ladite couche de porosité élevée (3) dudit substrat (1).

2. Procédé selon la revendication 1, **caractérisé en ce qu'**il comprend en outre l'étape d'interruption de l'application de courant pendant un laps de temps, et une nouvelle application du courant pour obtenir une plus grande épaisseur des couches poreuses.
